# EUROPEAN PATENT APPLICATION

(11) **EP 1 544 319 A2**
(43) Date of publication of application: **22.06.2005**
(21) Application number: 04028354.1
(22) Date of filing: 30.11.2004
(51) Int. Cl.: C23C 14/04, C23C 14/12

(54) **Deposition mask**

(30) Priority: 19.12.2003 JP 2003422803
(71) Applicant: SEIKO EPSON CORPORATION, Tokyo 160-0811 (JP)
(72) Inventor: Yotsuya, Shinichi, Suwa-shi, Nagano-ken 382-8502 (JP)
(74) Representative: HOFFMANN - EITLE

(57) **Abstract**

The present invention aims to provide a mask that can provide vapor deposition with high accuracy and be free from damage caused by an impact and the like, and a method for manufacturing such a mask; a method for manufacturing an organic electroluminescence device using the mask, and an organic electroluminescence device manufactured by the method: and electronic apparatus. A mask of the present invention has a plurality through-holes penetrating a substrate made of silicon with (100) orientation, and the mask includes a vertical part (20A) that is provided to a wall part of the through-hole and extends in a vertical direction to a principal plane of the substrate, and an inclined part (20B) that is provided to the wall part of the through-hole and extends in a predetermined oblique angle from the vertical part.

## Description

### [Technical Field]

The present invention relates to a mask, a method for manufacturing a mask, a method for manufacturing an organic electroluminescence device, an organic electroluminescence device, and electronic apparatus.

### [Background]

An organic electroluminescence (EL) device includes an emissive display element of high-speed response having a multilayer structure of thin films. This structure makes it possible to provide a display panel that is highly responsive to moving images. Therefore, such organic EL devices have attracted increasing attention as a display panel of a flat panel display (FPD) television in recent years. A typical method for manufacturing the devices includes the steps of patterning a transparent positive electrode made of indium tin oxide (ITO) or the like by photolithography with a desired pattern, forming a multilayer of organic materials by using a transparent-electrode resistance-heating vacuum evaporator, and then forming a negative electrode. The negative electrode is provided by depositing a film made of a metal material having a low work function, such as Mg and Ag. Light-emitting elements are sealed airtight in the presence of an inert gas, and protected against moisture, oxygen, and so on.

Furthermore, the color of emitted light is variable by using different light-emitting materials. More specifically, a full-color organic EL panel that provides extremely clear images is manufactured by depositing a red-, green-, or blue-light-emitting element to each pixel with a high-pixel-density metal mask that is adhered to a glass substrate by using a magnet with a specific magnetic force.

Here, greater panels require larger metal masks. However, it is extremely difficult to accurately produce a large, thin metal mask. In addition, since the thermal expansion coefficient of a metal mask is much larger than that of a panel glass substrate, the size of the metal mask becomes larger than that of the panel glass substrate because of radiant heat during vapor deposition. Therefore, the metal mask that is adhered to the panel glass substrate becomes out of alignment, causing dimensional differences in deposited portions. Such differences accumulate and become considerable when manufacturing a large panel. Therefore, it is considered that mask deposition can be employed for manufacturing small- or middle-size panels of about 20 inches at most.

Instead of that, a technique for manufacturing a mask using a Si substrate has been suggested recently (see Patent Document 1 below, for example). This technique employs a semiconductor manufacturing process, such as photolithography and dry etching, and uses the Si substrate itself as a mask. The thermal expansion coefficient of Si is almost the same as that of a panel glass substrate, and thereby causing no misalignment attributed to thermal expansion. Moreover, this technique provides extremely high processing accuracy. Meanwhile, a technique for etching a Si wafer of (100) orientation by anisotropic crystal etching so as to form a tapered opening at 54.7° has been also suggested (see Patent Document 2 below, for example). This technique provides an even film-thickness distribution in a vapor-deposition pattern.
[Patent Document 1] Japanese Unexamined Patent Publication No. 2001-185350.
[Patent Document 2] Japanese Unexamined Patent Publication No. 4-236758.

### [Disclosure of the Invention]

### [Problems to Be Solved]

The problem, however, is that Si substrates are brittle. The technique of Patent Document 1 requires that a portion having pixels be made thin so that vapor-deposition particles coming at an oblique angle to a substrate easily enter the pixels. Then there arises the problem of brittle masks that can be broken with even a small impact caused when contacting with the substrate. This problem prevents the technique from being put into practice.
The technique of Patent Document 2 is also disadvantageous in that a surface on which a substrate is adhered to a mask is easily damaged, because the opening is sharp at the end.

In consideration of the above-mentioned problems, the present invention aims to provide a mask that can provide vapor deposition with high accuracy and be free from damage caused by an impact and the like, and a method for manufacturing such a mask; a method for manufacturing an organic EL device using the mask, and an organic EL device manufactured by the method; and electronic apparatus.

### [Means to Solve the Problems]

In order to achieve the above-mentioned object, the present invention employs the following structure.
A mask of the present invention has a plurality through-holes penetrating a substrate made of silicon with (100) orientation, and the mask includes a vertical part that is provided to a wall part of the through-hole and extends in a vertical direction to a principal plane of the substrate, and an inclined part that is provided to the wall part of the through-hole and extends in a predetermined oblique angle from the vertical part.
With this structure, since the wall part of each through-hole is provided with the vertical part, it is possible to increase the sectional area of the mask. This prevents bending and damage such as peeling, and thereby increasing the strength of the mask. Although substrates made of silicon are comparatively brittle and disadvantageous in strength, providing the wall part of the through-hole with the vertical part as in the present invention can solve this problem.

Since the wall part of the through-hole is also provided with the inclined part according to the present invention, the through-hole has a wide-angle area extending to at least one principal plane of the mask. When performing film-forming processes, e.g. vapor deposition and sputtering, using the mask, a gaseous material and atoms coming at an oblique angle to the vertical direction of the principal plane of the substrate are provided via the wide-angle area to form a film on an object on which a film is formed (hereinafter called "film-formed object"). Therefore, the film of the gaseous material and atoms can be formed on such a film-formed object in accordance with the pattern of the through-hole. If the wall part of the through-hole is provided only with the vertical part, there remains an area in the vicinity of the vertical part in which no film is formed since no gaseous material and atoms reach. Providing the wall part of the through-hole with the inclined part makes such an gaseous material and atoms coming at an oblique angle reach this area as well, and films can be formed in this area. '
Accordingly, with the above-mentioned structure of the wall part of the through-hole having both the vertical part and the inclined part, it is possible not only to increase the strength against bending, peeling, and the like, but also to make a gaseous material and atoms adequately reach an object. Therefore, films can be surely and accurately formed with a predetermined pattern on a film-formed object.

Of the vertical part and the inclined part, the vertical part is preferably provided on the side that contacts with a film-formed object.
For example, if the inclined part is provided on the side contacting with a film-formed object, and films are formed in this state of things, the mask and the film-formed object may be joined by the material that is formed into a film, resulting in the damage of the inclined part and the deformation of the mask in an effort to remove the mask.
Meanwhile, if the vertical part is provided on the side contacting with such a film-formed object, there remains a small area in the vicinity of the vertical part in which no film is formed since a gaseous material and atoms come at an oblique angle. Therefore, the mask and the film-formed object are not joined, which can prevent damage, deformation, etc. while removing the mask.

In the mask, at least one crystal plane of the inclined part may be a plane with (111) orientation.
With this structure, the mask includes the inclined part of the (111) plane on the substrate made of silicon with (100) orientation. The (111) plane is formed by anisotropic crystal etching of a (100) plane, which requires no physical processing such as grinding and easily forms the mask by chemical processing.

Also in the mask, the length of the vertical part is from one-twentieth to one-half inclusive of a distance between adjacent two of the plurality of through-holes.
If the vertical part is longer than one-half of the distance, only particles flying vertically to a film-formed object can reach its substrate during various film-forming processes. Therefore, it is not possible to form films extensively inside the through-hole. On the other hand, if the vertical part is shorter than one-twentieth of the distance, the mask cannot be adequately strong.
Consequently, by setting the length of the vertical part from one-twentieth to one-half inclusive of the distance between adjacent two through-holes, it is possible provide preferable strength and make a gaseous material and atoms surely and accurately reach a film-formed object.

A method for manufacturing a mask of the present invention provides a mask having a plurality through-holes penetrating a substrate made of silicon with (100) orientation. The method includes the following steps: forming a first protective member that is highly resistant to etching to a substrate plane including at least a first side of the substrate; selectively removing the first protective member with a predetermined pattern on the first side and forming a hole part at a removed portion; forming a second protective member that is highly resistant to etching to a substrate plane including at least the first side of the substrate; removing the second protective member that is provided on a bottom part of the hole part and penetrating a second side of the substrate and the hole part; and performing anisotropic crystal etching to the substrate.

With this method, the vertical part and the inclined part can be easily provided to the wall part of the through-hole. Accordingly, it is possible to provide the mask M capable of not only increasing the strength against bending, peeling, and so on, but also making a gaseous material and atoms adequately reach an object. Therefore, films can be surely and accurately formed with a predetermined pattern on such a film-formed object with the mask.
Also, since the method includes the steps of forming and then partly removing the first protective member, the hole part can be formed only in a desired portion.
Moreover, since the substrate has a portion where the first and second protective members are stacked and another portion where protective member is separately provided in a single layer, it is possible to expose the surface of the surface at the bottom part of the hole part by making use of differences in the thickness of the stacked layer and the single layer.
In addition, since the method includes the step of penetrating the second side and the hole part, a portion to be the vertical part can be formed.
Furthermore, since the method includes the step of anisotropic crystal etching, it is possible to form a (111) crystal plane on a substrate with (100) orientation, and thereby forming a portion to be the inclined part.

The method for manufacturing a mask may also include, before the step of penetrating the second side of the substrate and the hole part, the step of exposing the surface of the substrate on the second side and etching the surface of the substrate.
With this method, by etching the second side, it is possible to reduce the thickness of the substrate between the first and second sides. Accordingly, it is possible to reduce the depth to which the second side of the substrate and the hole part are penetrated in the step of penetrating them, and to simplify this step.

The method for manufacturing a mask may also include, after the step of performing anisotropic crystal etching, the step of removing the first protective member and the second protective member.
With this method, it is possible to remove a stress remaining inside the first and second protective members by removing the first and second protective members from the mask, and to prevent bending of the mask caused by the stress.

A method for manufacturing an organic EL device of the present invention provides an organic EL device by depositing a plurality of materials to a substrate with a predetermined pattern. The method uses the above-mentioned mask.
Using the mask that is strong and provides various film-forming processes with high accuracy makes it possible to manufacture the organic EL device that has a desirable film-thickness distribution in planes of the substrate and in pixels, provides even luminous intensity of emitted light, and displays clear images free from uneven display.

An organic EL device of the present invention is manufactured by using the above-mentioned method for manufacturing.
The organic EL device provides even luminous intensity of emitted light, and displays clear images free from uneven display.

Electronic apparatus of the present invention include the above-mentioned organic EL device.
Examples of the electronic apparatus may include cellular phones, mobile data terminals, watches, and data processing devices such as word processors and personal computers.
The electronic apparatus are equipped with a display part using the above-mentioned organic EL device. Therefore, the electronic apparatus of the present invention have a display part that provides even luminous intensity of emitted light, and displays clear images free from uneven display.

### [Brief Description of the Drawings]

[FIG. 1] FIG. 1A is a sectional perspective view illustrating the structure of a mask according to the present invention. FIG. 1B is a sectional view showing a detailed structure of the mask.
[FIG. 2] FIG. 2 illustrates steps of manufacturing the mask according to the present invention.
[FIG. 3] FIG. 3 illustrates steps of manufacturing the mask according to the present invention.
[FIG. 4] FIG. 4 illustrates vapor deposition using the mask according to the present invention.
[FIG. 5] FIG. 5 illustrates steps of manufacturing an organic electroluminescence device using the mask according to the present invention.
[FIG. 6] FIG. 6 shows electronic apparatus having the organic electroluminescence device according to the present invention.

### [Description of Preferred Embodiments]

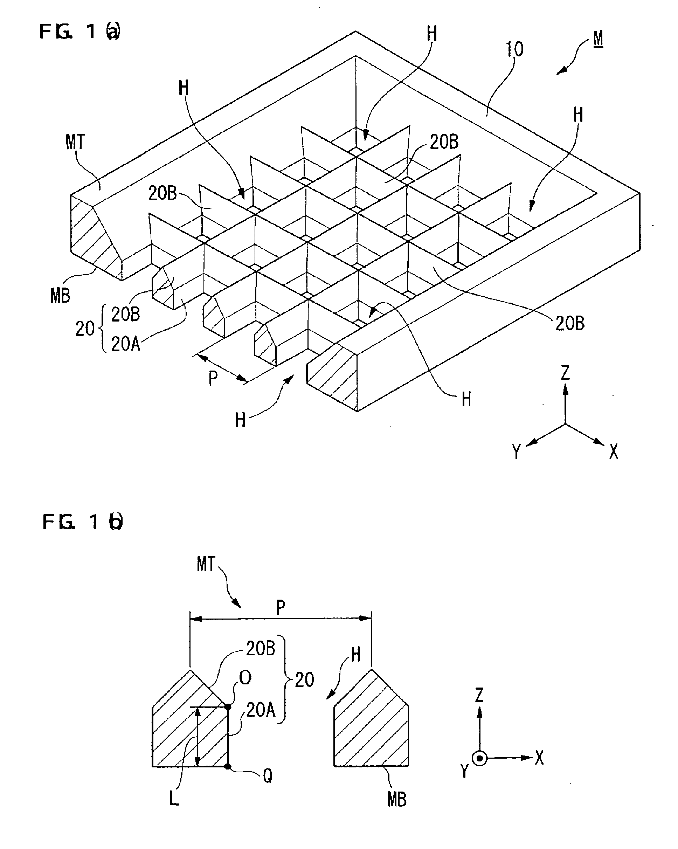

Referring to FIGs. 1 through 6, a mask, a method for manufacturing a mask, a method for manufacturing an organic EL device, an organic EL device, and electronic apparatus according to the present invention will be described.
The following description is not intended to limit the present invention. It is understood that various modifications can be made without departing from the spirit and scope of the present invention. In the accompanying drawings, the scale of each layer and each member is adequately changed, so that they are visible.

### (Mask)

FIGs. 1 illustrates the structure of the mask according to the present invention. FIG. 1A is a sectional perspective view of the mask. FIG. 1B is a sectional view showing a detailed structure around its through-hole.
As shown in FIG. 1A, a mask M includes an outer frame 10 that defines the outer shape of the mask M, and a through-hole H that is provided in the plural number inside the outer frame 10. The mask M is made by processing a silicon wafer (substrate) with (100) orientation as described later. The outer frame 10 is formed by making use of the thickness of the silicon wafer. As described as the characteristics of the present invention, a wall part 20 of the through-hole H is provided with a vertical part 20A and an inclined part 20B.

As shown in FIG. 1B, the vertical part 20A is formed so as to extend vertically (in the Z direction) to principal planes MT and MB of the mask M, while the inclined part 20B is formed so as to extend at a predetermined angle, which will be described later, to the Z direction. Moreover, the vertical part 20A and the inclined part 20B are connected each other at a contact point O and provided uninterruptedly. An end Q of the vertical part 20A is connected to the back plane MB of the mask M.
The back plane MB is on the side that directly contacts with a film-formed object by film-forming processes, such as vapor deposition and sputtering, as described in greater detail later to describe how to use the mask M. The back plane MB is also on the side that a gaseous material and atoms reach such a film-formed object. Meanwhile, the front plane MT of the mask M is on the side to which the gaseous material and atoms enter to reach such a film-formed object by such film-forming processes. The front plane MT is also on the side on which the inclined part 20B is provided.
The length L of the vertical part 20A is set within the range from one-twentieth to one-half inclusive of the pitch P (distance between a point on one through-hole and a corresponding point on an adjacent through-hole) of the through-hole H.
The inclined part 20B has a surface composed of a (111) crystal plane. The (111) crystal plane is provided at an angle of 54.7° to the back plane MB. Therefore, a gaseous material and atoms coming at an oblique angle can reach a film-formed object without being interrupted.
Moreover, as shown in FIG. 1A, the wall part 20 (the vertical part 20A and the inclined part 20B) extends in the flat direction of the mask M, i.e. in the X and Y directions, like putting up beams in the outer frame 10. The through-hole H is thus provided in the plural number in a matrix with this beam structure.
While the through-hole H is provided in the plural number in a matrix at a certain pitch in the present embodiment, it is not intended to limit the present invention, and can be adequately changed according to the pattern to be formed on the film-formed object. For example, the wall part 20 can be provided only in the Y direction, and at various pitches.

As described above, the mask M of the present embodiment is provided with the vertical part 20A included in the wall part 20 of the through-hole H, which increases the sectional area of the mask M. This prevents bending and damage such as peeling, and thereby increasing the strength of the mask M. Although masks made of silicon are comparatively brittle and disadvantageous in strength, providing the wall part 20 of the through-hole H with the vertical part 20A as in the present embodiment can solve this problem.

The wall part 20 of the through-hole H is also provided with the inclined part 20B. Therefore, the through-hole H has a wide-angle area extending to at least one principal plane of the mask M. When performing film-forming processes, e.g. vapor deposition and sputtering, using the mask, a gaseous material and atoms coming at an oblique angle to the vertical direction of the principal plane of the substrate are provided via the wide-angle area to form a film on a film-formed object. Therefore, the film of the gaseous material and atoms can be formed on such a film-formed object in accordance with the pattern of the through-hole. If the wall part 20 of the through-hole H is provided only with the vertical part 20A, there remains an area in the vicinity of the vertical part 20A in which no film is formed since no gaseous material and atoms reach. Providing the wall part 20 of the through-hole H with the inclined part 20B makes such an gaseous material and atoms coming at an oblique angle reach this area as well, and films can be formed in this area.
Accordingly, with the above-mentioned structure of the wall part 20 of the through-hole H having both the vertical part 20A and the inclined part 20B, it is possible not only to increase the strength against bending, peeling, and the like, but also to make a gaseous material and atoms adequately reach an object. Therefore, films can be surely and accurately formed with a predetermined pattern on a film-formed object.

Of the vertical part 20A and the inclined part 20B, the vertical part 20A is preferably provided on the side that contacts with a film-formed object.
For example, if the inclined part 20B is provided on the side contacting with a film-formed object, and films are formed in this state of things, the mask M and the film-formed object may be joined by the material that is formed into a film, resulting in the damage of the inclined part 20B and the deformation of the mask M in an effort to remove the mask M. Meanwhile, if the vertical part 20A is provided on the side contacting with such a film-formed object, there remains a small area in the vicinity of the vertical part 20A in which no film is formed since a gaseous material and atoms come at an oblique angle. Therefore, the mask M and the film-formed object are not joined, which can prevent damage, deformation, etc. while removing the mask M.

The crystal plane of the inclined part 20B is (111) orientation. This means that the mask M has the inclined part 20B of (111) orientation on a substrate made of silicon with (100) orientation. The (111) plane is formed by anisotropic crystal etching of a (100) plane, which requires no physical processing such as grinding and easily forms the mask M by chemical processing.

In addition, the length of the vertical part 20A is set within the range from one-twentieth to one-half inclusive of the pitch P of the through-hole H, which can provide preferable strength and make a gaseous material and atoms surely and accurately reach a film-formed object.

### (Method for Manufacturing Mask)

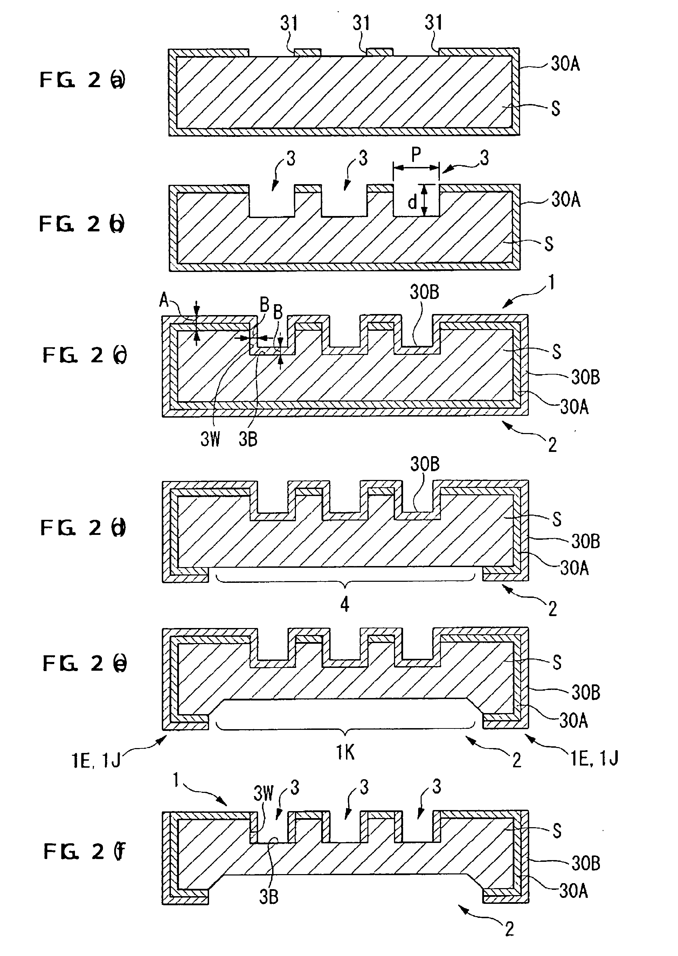

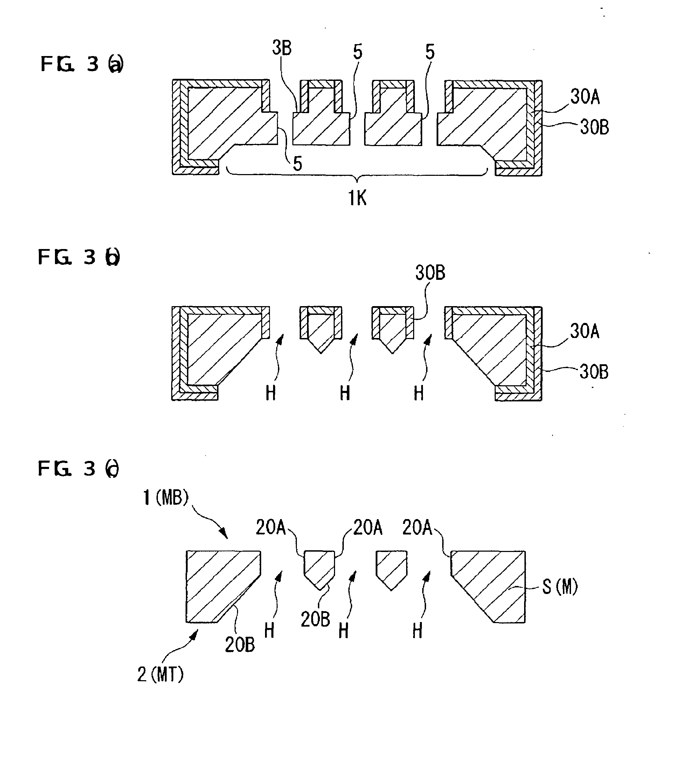

Referring now to FIGs. 2 and 3, a method for manufacturing the mask M shown in FIG. 1 will be described.
FIGs. 2 and 3 are sectional views of the mask M shown in FIG. 1 and illustrate steps of manufacturing the mask M.

First, as shown in FIG. 2A, a substrate S made of silicon with (100) orientation is thermally oxidized so as to form a first etching resistant mask (first protective member) 30A (step of forming a first protective member).
The first etching resistant mask 30A is a film that is resistant to an crystal anisotropic etchant (e.g. a water solution of potassium hydroxide, sodium hydroxide, or tetramethylammonium hydroxide), and preferably made of a sputtered film of silicon oxide, silicon nitride, silicon carbide, Au, or Pt.
The first etching resistant mask 30A of the present embodiment is a silicon oxide film that is formed by thermal oxidation. The thickness of the silicon oxide film is preferably about 1 µm.

The first etching resistant mask 30A, which is formed by thermal oxidation, is provided with a vertical opening 31 at a portion to be the through-hole H.
The opening 31 is formed by a known photolithography and dry etching process.

Subsequently, as shown in FIG. 2B, a portion of the first etching resistant mask 30A corresponding to the opening 31 is dry etched so as to form a hole part to a predetermined depth d (step of forming a hole part).
Here, deep reactive ion etching (RIE) adopted by Micro Electro Mechanical Systems (MEMS) is used as a dry etching technique. By using this method, the depth d of the hole part 3 is determined. The depth d corresponds to the length L of the vertical part 20A shown in FIG. 1. Therefore, the depth d of etching performed in this step depends on the pitch P of the through-hole H that is formed in a later step, and is preferably shallower than one-half of the pitch P and deeper than one-tenth of the pitch P.

Then, as shown in FIG. 2C, the substrate S is again thermally oxidized so as to form a silicon oxide film to be a second etching resistant mask (second protective member) 30B to a thickness of about 1 µm on the whole surface of the substrate S (step of forming a second protective member).
The first etching resistant mask 30A, which has been formed earlier, and the second etching resistant mask 30B, which is formed in this step, are stacked on a first side 1 and a second side 2 of the substrate S to an accumulated thickness A of about 2 µm.
A bottom part 3B and a wall part 3W of the hole part 3, which have been formed by the deep RIE, are provided with the silicon oxide film to a thickness B of about 1 µm directly on the silicon substrate in this step.
Consequently, the thickness A of the stacked first and second etching resistant masks 30A and 30B is larger than the thickness B of the second etching mask 30B provided directly on the silicon substrate.

Then, as shown in FIG. 2D, the first and second etching resistant masks 30A and 30B formed on the second side 2 of the substrate S are peeled off with a predetermined pattern by applying a known photolithography and dry etching process to the second side 2 so as to form an exposed part 4.

Subsequently, as shown in FIG. 2E, the substrate S is made thin to reach a predetermined thickness by applying a wet etching process using a solution of potassium hydroxide (step of etching the surface of the substrate).
Here, wet etching is performed as follows.
The wet etching process is performed by immersing the substrate S in a solution of 20 weight percent potassium hydroxide heated up to 80 degrees centigrade.
In this wet etching process, since the substrate S is made of a silicon material of (100) orientation, anisotropic crystal etching is performed on the substrate S. The etching of the substrate S depends on the orientation of crystal. For example, the etching is performed utilizing the property that an etching rate of a (111) plane is slower than that of a (100) plane. Since the substrate S is of (110) orientation, an etching rate of this (100) plane is slower than that of a (111) plane. Thus, the etching of the (111) plane proceeds faster, and thereby forming the inclined part 20B. The angle of the (111) plane is 54.7°.

Examples of etchants used for this wet etching process may include, other than the solution of potassium hydroxide, an alkaline solution of organic amine, e.g. a 10 to 30 weight percent solution of tetramethylammonium hydroxide (especially, 10 to 20 weight percent) heated up to about 80 degrees centigrade. Instead of the solution of potassium hydroxide, an inorganic alkaline solution, e.g. ammonia water, can also be used. Using such an alkaline solution without potassium or sodium can prevent the mask M from being contaminated while manufacturing the mask M, and also prevent a film-formed object from being contaminated during vapor deposition performed by using the mask M.

As a result of utilizing the anisotropic crystal etching as mentioned above, the exposed part 4 on the second side 2 of the substrate S is etched. Accordingly, a portion of the substrate S other than an edge region 1E is made thin. Here, a thin part 1K is formed. Meanwhile, a portion corresponding to the edge part 1E of the substrate S remains unetched. Here, a thick part 1J is formed.

Subsequently, as shown in FIG. 2F, dry etching is performed on the whole surface (including the first side 1 and the second side 2) of the substrate S.
As the dry etching process, anisotropic etching by RIE is preferably used here. By using this dry etching process, the second etching resistant mask 30B that is provided on the first side 1 of the substrate S and the second etching resistant mask 30B that is provided on the bottom part 3B of the hole part 3 are removed by a thickness of about 1 µm. In this anisotropic etching process, the silicon oxide film on the bottom part 3B of the hole 3 is removed by the action of activated etching ion species coming in the vertical direction of the substrate, while the activated etching ion acts little on the wall part 3W. Therefore, the silicon oxide film on the wall part 3W remains almost unremoved.

The RIE-10NR manufactured by Samco International is preferably used in the above-mentioned dry etching process. Moreover, etching is preferably performed with CHF₃ gas used as an etching gas, at a gas flow of 30 sccm, supply power of 200 W, and process voltage of 0.03 Torr.
Dry etching under this condition provides an etching rate of 30 nm per minute on a silicon oxide film.

Subsequently, as shown in FIG. 3A, a through-hole part 5 is formed by a penetrating process so as to run through the bottom part 3B of the hole part 3 and the thin part 1K of the substrate S (step of penetrating the second side and the hole part).
Here, yttrium-aluminum-garnet (YAG), CO₂, or other lasers are preferably used for the penetrating process. The through-hole part 5 is formed by irradiating a portion corresponding to the bottom part 3B of the hole part 3 with a laser light. As shown in the drawing, the diameter of the through-hole 5 is made smaller than the diameter of the hole part 3. In order to form the through-hole 5, other processing methods as follows than using a laser light can also be applied: microblasting using fine abrasive particles for jet blast; time-modulation plasma etching alternately forming a side-wall protection film and performing etching; and machining using a drill or the like. These methods can also provide the substrate S with the through-hole part 5.

Then, as shown in FIG. 3B, wet etching using a water solution of potassium hydroxide, that is, anisotropic crystal etching is conducted in the same manner as mentioned above.
Accordingly, the through-hole H that is made up of the inclined part 20B of the (111) crystal plane of the substrate S, and the vertical part 20A is provided.

Then, as shown in FIG. 3C, the substrate S is immersed in a buffer solution of hydrofluoric acid (step of removing the first etching resistant mask and the second protective member).
Thus, the first and second etching resistant masks 30A and 30B covering the substrate S are removed, which completes the mask M.
The mask M has the first side 1 corresponding to the mask back plane MB and the second side 2 corresponding to the mask front plane MT.

While the mask M provided with three of the through-hole H is described in the steps illustrated in FIGs. 2 and 3, a completed mask has 206 (lengthwise) by 176 (crosswise) through-holes. The pixel size of the mask M manufactured thereby is 0.05 mm by 0.16 mm with a pitch of 0.2 mm. The vertical part 20A is 15 µm long. The length between the peak of the inclined part 20B and the part connecting the vertical part 20A and the inclined part 20B is 100 µm.

The present method for manufacturing a mask makes it easy to provide the wall part 20 of the through-hole H with the vertical part 20A and the inclined part 20B. Accordingly, it is possible to provide the mask M capable of not only increasing the strength against bending, peeling, and so on, but also making a gaseous material and atoms adequately reach an object. Therefore, films can be surely and accurately formed with a predetermined pattern on such a film-formed object with the mask M.
Also, since the method includes the steps of forming and then partly removing the first etching resistant mask 30A, the hole part 3 can be formed only in a desired portion.
Moreover, since the substrate S has a portion where the first and second etching resistant masks 30A and 30B are stacked and another portion where each of the first and second etching resistant masks 30A and 30B is separately provided in a single layer, it is possible to expose the surface of the surface S at the bottom part 3B of the hole part 3 by making use of differences in the thickness of the stacked layer and the single layer.
In addition, since the method includes the step of penetrating the second side 2 and the hole part 3, a portion to be the vertical part 20A can be formed.
Furthermore, since the method includes the step of anisotropic crystal etching, it is possible to form a (111) crystal plane on a substrate with (100) orientation, and thereby forming a portion to be the inclined part 20B.

Since the method for manufacturing a mask includes, before the step of penetrating the second side 2 and the hole part 3, the step of exposing the surface of the substrate S on the second side 2 and directly etching the substrate S, it is possible to make the substrate between the first side 1 and the second side 2 thin by etching the second side 2. Accordingly, it is possible to reduce the depth to which the second side 2 and the hole part 3 are penetrated in the step of penetrating them, and to simplify this step.

Also, since the method also includes, after the anisotropic crystal etching, the step of removing the first and second etching resistant masks 30A and 30B, it is possible to remove a stress remaining inside the first and second etching resistant masks 30A and 30B, and to prevent bending of the mask M caused by the stress.

### (Method for Using Mask)

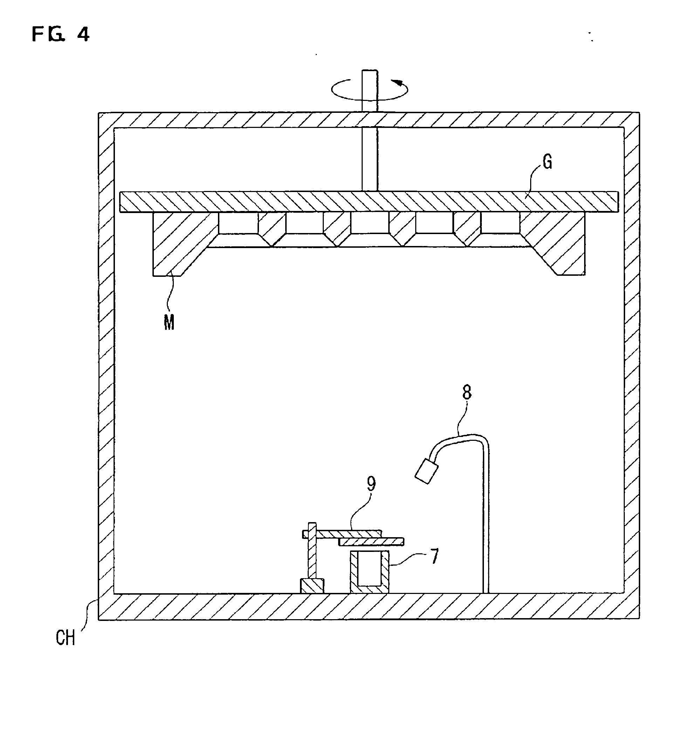

Referring now to FIG. 4, a method for using a mask will be described.
In the present embodiment, a method of vapor deposition using a mask will be described.
FIG. 4 is a diagram illustrating vapor deposition using the mask M shown in FIGs. 1 and 2.
As shown in FIG. 4, a vapor deposition source 7 is located at the bottom part of a vacuum chamber CH. The mask M for vapor deposition (hereinafter called "deposition mask M") is placed above the source. On top of that, a glass substrate G that is a film-formed object is adhered to the deposition mask M for performing vapor deposition. The whole structure may be rotated with the glass substrate G and the deposition mask M fixed as shown in FIG. 4 during vapor deposition in order to improve a film-thickness distribution. A film-thickness sensor 8 of a crystal oscillator controls the speed at which the deposition source 7 evaporates (i.e. vapor deposition rate) in order to strictly control the thickness of films. When the film-thickness sensor 8 detects that the thickness of a deposited film reaches a predetermined value, a shutter 9 directly upon the deposition source 7 is closed to stop the vapor deposition process, the deposition mask M and the glass substrate G that have been fixed are released, and only the glass substrate G is taken out.
Even if this process is repeated thirty times a day, no damage or unusual bending of the deposition mask M, which are observed with conventional masks, will not occur. Therefore, the mask can be used in a stable manner.
While the mask M is used as a deposition mask in the present embodiment, the mask can also be used as a mask for sputtering or a mask for chemical vapor deposition (CVD).

### (Method for Manufacturing Organic EL Device)

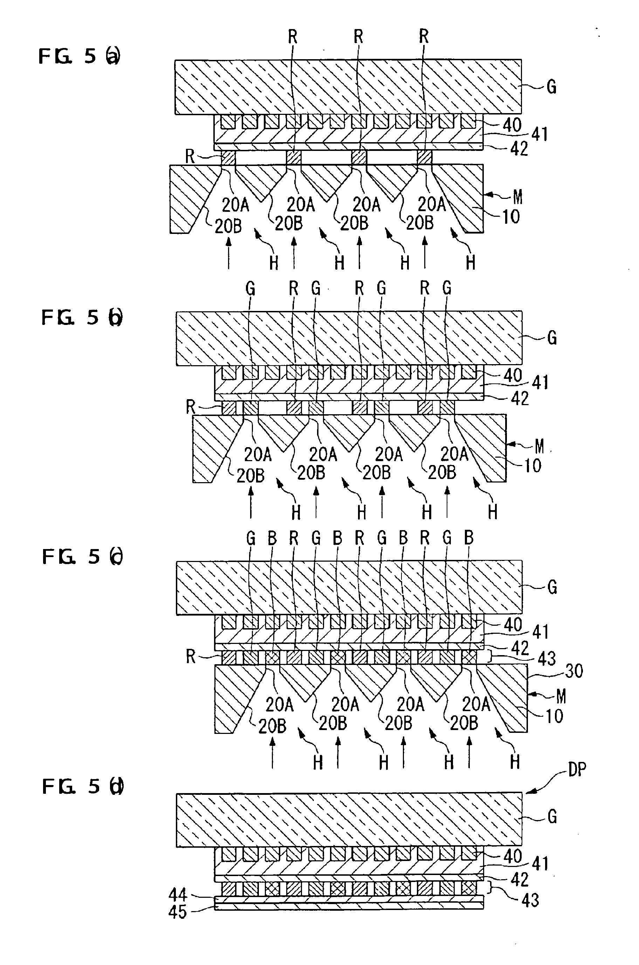

Referring now to FIG. 5, a method that uses the mask M of the present invention in order to deposit a material for forming an organic EL device on the glass substrate G that is a film-formed object will be described.
As shown in FIG. 5A, a switching element such as a thin film transistor is formed on the glass substrate G. Coupled to the switching element is a positive electrode 40. In addition, a hole injection layer 41 and a hole transportation layer 42 are provided so as to be coupled to the positive electrode 40.

A material R for forming a red-light-emitting layer is deposited on the glass substrate G while making the mask M adhere to the glass substrate G (hole transportation layer 42). The material R for forming a red-light-emitting layer is thus deposited on the glass substrate G in line with the through-hole H of the mask M.
Next, as shown in FIG. 5B, a material G for forming a green-light-emitting layer is deposited on the glass substrate G while moving the mask M from its first position relative to the glass substrate G (or using another mask M) and making the mask M adhere to the glass substrate G (hole transportation layer 42). The material G for forming a green-light-emitting layer is thus deposited on the glass substrate G in line with the through-hole H of the mask M.
Next, as shown in FIG. 5C, a material B for forming a blue-light-emitting layer is deposited on the glass substrate G while moving the mask M from its second position relative to the glass substrate G (or using yet another mask M) and making the mask M adhere to the glass substrate G (hole transportation layer 42). The material B for forming a blue-light-emitting layer is thus deposited on the glass substrate G in line with the through-hole H of the mask M.
In this way, a light-emitting layer 43 made of red, green, and blue organic materials is formed on the glass substrate G.

Subsequently, as shown in FIG. 5D, an electron transport layer 44 and a negative electrode 45 are provided on the light-emitting layer 43, which completes an organic EL device DP.

The organic EL device DP according to the present embodiment extracts light emitted from a light-emitting element including the light-emitting layer from the substrate G side to the outside of the device. In this case, examples of materials for forming the substrate G include not only transparent glass materials, but also transparent or translucent materials that transmit light, such as quartz, sapphire, and transparent synthetic resin materials including polyester, polyacrylate, polycarbonate, and polyether ketone. In particular, soda glass, which is economical, is suitably used as the material for forming the substrate G.

Meanwhile, if the device extracts emitted light from the opposite side to the substrate G, the substrate G may be opaque. In this case, ceramic materials such as alumina, metal sheets made of stainless steel or the like that are insulated by a surface oxidation process etc., thermosetting resin, thermoplastic resin, and other materials can be used.

The positive electrode can be made of either one of Al, Au, Ag, Mg, Ni, ZnV, In, Sn, or a compound or mixture of these materials, or a conductive adhesive including a metal filler. In the present embodiment, ITO is used to make the positive electrode. The positive electrode is preferably formed by sputtering, ion plating, or vacuum vapor deposition, and may also be formed by wet process coating using a spin coater, gravure coater, knife coater, or the like, screen printing, or flexographic printing.
The light transmittance of the positive electrode is preferably set at 80% or more.

As the hole transportation layer, for example, carbazole polymer and TPD (triphenyl compound) are codeposited to a thickness of 10 to 1000 nm (preferably from 100 to 700 nm).
Here, materials of the hole transportation layer 6 are not particularly limited, and known materials can be used, for example, pyrazoline derivatives, arylamine derivatives, stilbene derivatives, and triphenyldiamine derivatives. More detail examples can be found in Japanese Unexamined Patent Publication Nos. 63-70257, 63-175860, 2-135359, 2-135361, 2-209988, 3-37992, and 3-152184. Among others, triphenyldiamine derivatives are preferably used, and 4,4'-bis(N(3-methylphenyl)-N-phenylamino)biphenyl is particularly preferable.

Materials of the hole injection layer may include copper phthalocyanine (CuPc), polyphenylene vinylene that is polytetrahydrothiophenylphenylene, 1,1-bis-(4-N,N-di-tolylaminophenyl)cyclohexane, and tris(8-hydroxyquinolinol)aluminum. In particular, copper phthalocyanine (CuPc) is preferably used.

Another method for forming the hole transportation layer on a positive electrode is ejecting an ink composition including a material of the hole injection or hole transportation layer on the positive electrode by a droplet ejection method (ink jetting) and then performing drying and heat treatment. More specifically, the hole transportation layer (hole injection layer) is formed on a positive electrode by ejecting an ink composition including a material of the hole transportation or hole injection layer on the electrode plane of the positive electrode and then performing drying and heat treatment. This process is done by, for example, filling an inkjet head (not shown) with such an ink composition including the material of the hole transportation or hole injection layer, placing the ejection nozzle of the inkjet head face to face with the electrode plane of the positive electrode, and ejecting ink droplets, with an amount per drop under control, from the ejection nozzle while moving the inkjet head relatively to the substrate 1. Then, the ejected ink droplets are dried so that a polar solvent included in the ink composition will evaporate, which completes the hole transportation layer (hole injection layer).

An example of the ink composition is a mixture of a polythiophene derivative (e.g. polyethylenedioxythiophene) and polystyrene sulfonate etc. that are dissolved in a polar solvent (e.g. isopropyl alcohol). The ejected ink droplets extend on the electrode plane of the positive electrode that has been processed to be ink receptive. Meanwhile, ink droplets do not adhere to the top surface of an insulating film that has been processed to be ink repellent. Therefore, even if ink droplets are out of alignment to a predetermined position and ejected on the top surface of such an insulating film, the top surface does not get wet with the ink droplets and the repelled ink droplets are considered to flow onto the positive electrode 5.

Examples of light-emitting materials making up the light emitting layer include fluorine polymer derivatives, (poly) paraphenylene vinylene derivatives, polyphenylene derivatives, polyfluorine derivatives, polyvinylcarbazole, polythiophene derivatives, perylene dyes, coumarin dyes, rhodamine dyes, and other low-molecular-weight organic EL materials that are soluble to benzene derivatives.

The electron transport layer can be made of metal complex compounds that are composed of a metal material and an organic ligand. Preferably, Alq3 (tris(8-quinolinolato) aluminum complex), Znq2 (bis(8-quinolinolato) zinc complex), Bebq2 (bis(8-quinolinolato) beryllium complex), Zn-BTZ (2-(o-hydroxyphenyl) benzothiazole zinc), and perylene derivatives are deposited and stacked to a thickness of 10 to 1000 nm (more preferably, 100 to 700 nm).

The negative electrode can be made of a metal material having a work function that is low enough to efficiently inject electrons into the electron transport layer, such as Ca, Au, Mg, Sn, In, Ag, Li, Al, or alloys or compounds of these materials. In the present embodiment, a negative electrode mainly made of Ca and a reflective layer mainly made of Al make up a two-layer structure.

As mentioned above, the present method for manufacturing the organic EL device DP employs vapor deposition using the above-mentioned mask.
Using the mask that is strong and provides various film-forming processes with high accuracy makes it possible to manufacture the organic EL device DP that has a desirable film-thickness distribution in planes of the substrate and in pixels, provides even luminous intensity of emitted light, and displays clear images free from uneven display.

The organic EL device DP according to the present embodiment is an active matrix type in which a plurality of data lines and a plurality of scan lines are arranged in a grid, and each pixel defined by the data lines and scan lines and arranged in a matrix is coupled to the light-emitting element through a driving TFT such as a switching transistor or a driving transistor. When a drive signal is supplied through the data lines and scan lines, an electrical current flows between electrodes, the light-emitting element emits light to the outer surface of a transparent substrate, making its pixel turn on. It is understood that the present invention is applicable not only to the active matrix type, but also to passive-drive display elements.

In order to prevent the air from coming from outside into the light-emitting element including an electrode, a sealing member that is not shown in the drawings is provided. The sealing member can be made of transparent or translucent materials, such as glass, quartz, sapphire, and synthetic resin materials. Here, glass materials include soda-lime glass, lead alkali glass, borosilicate glass, aluminosilicate glass, and silica glass. Synthetic resin materials include polyolefins, polyester, polyacrylate, polycarbonate, and polyether ketone.

### (Electronic Apparatus)

Electronic apparatus including the organic EL device DP according to the above-mentioned embodiment will now be described.

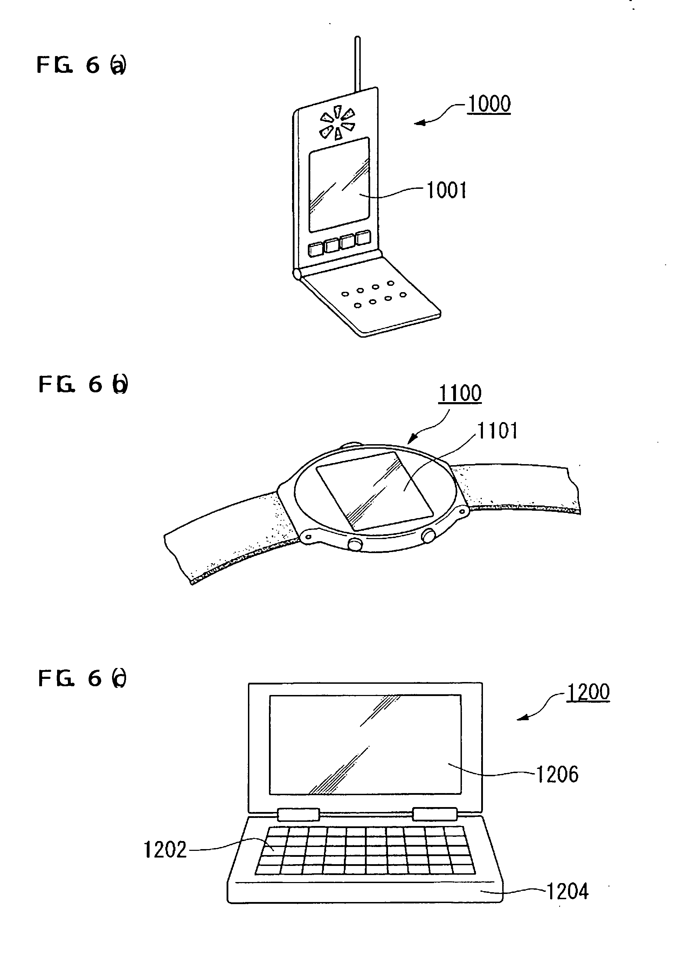

FIG. 6A is a perspective view showing an example of cellular phones. FIG. 6A shows a body 1000 of a cellular phone and a display part 1001 using the organic EL device DP.

FIG. 6B is a perspective view showing an example of wristwatch types of electronic apparatus. FIG. 6B shows a body 1100 of a wristwatch and a display part 1101 using the organic EL device DP.
FIG. 6C is a perspective view showing an example of portable data processing devices such as word processors and personal computers. FIG. 6C shows a data processing device 1200 including an input part 1202 such as a keyboard, a body 1204 of the data processing device, and a display part 1206 using the organic EL device DP.
Since the electronic apparatus shown in FIGs. 6A through 6C are equipped with the organic EL device DP according to the above-mentioned embodiment, the electronic apparatus have a display part that provides even luminous intensity of emitted light, and displays clear images free from uneven display.

It is understood that the present invention can be applied not only to the above-mentioned cellular phones etc., but also to various kinds of electronic apparatus. The present invention can also be applied to, for example, notebook computers, liquid crystal projectors, personal computers and engineering work stations (EWS) for multimedia applications, pagers, word processors, televisions, video recorders of viewfinder types or direct monitor types, electronic notebooks, electric calculators, car navigations systems, point-of-sale (POS) terminals, and apparatus equipped with a touch panel.

### [Reference Numerals]

S: Substrate
H: Through-hole
M: Mask
P: Pitch (distance between a point on one through-hole and a corresponding point on an adjacent through-hole)
1: First side
2: Second side
3: Hole part
3B: Bottom part
20: Wall part
20A: Vertical part
20B: Inclined part
30A: First etching resistant mask (first protective member)
30B: Second etching resistant mask (second protective member)
MT, MB: Principal plane
DP: Organic electroluminescence device

## Claims

1. A mask including a plurality of portions each defining a through-hole that penetrates a substrate made of silicon with (100) orientation, comprising:
a vertical part that is provided to a wall part of the through-hole and extends in a vertical direction to a principal plane of the substrate; and
an inclined part that is provided to the wall part of the through-hole and extends in a predetermined oblique angle from the vertical part.

2. The mask according to Claim 1, wherein at least one crystal plane of the inclined part is a plane with (111) orientation.

3. The mask according to Claim 1 or 2, wherein a length of the vertical part is from one-twentieth to one-half inclusive of a distance between one through-hole and another adjacent through-hole.

4. A method for manufacturing a mask including a plurality of portions each defining a through-hole that penetrates a substrate made of silicon with (100) orientation, comprising:
forming a first protective member that is highly resistant to etching to a substrate plane including at least a first side of the substrate;
selectively removing the first protective member with a predetermined pattern on the first side and forming a hole part at a removed portion;
forming a second protective member that is highly resistant to etching to a substrate plane including at least the first side of the substrate;
removing the second protective member that is provided on a bottom part of the hole part and penetrating a second side of the substrate and the hole part; and
performing anisotropic crystal etching to the substrate.

5. The method for manufacturing a mask according to Claim 4, further comprising:
exposing a surface of the substrate on the second side and etching the surface of the substrate, prior to penetrating the second side of the substrate and the hole part.

6. The method for manufacturing a mask according to Claim 4 or 5, further comprising:
removing the first protective member and the second protective member, subsequent to performing the anisotropic crystal etching.

7. A method for manufacturing an organic electroluminescence device that is formed by depositing a plurality of materials to a substrate with a predetermined pattern, wherein the mask according to any one of Claims 1 through 3 is used.

8. An organic electroluminescence device, wherein the organic electroluminescence device is manufactured by using the method for manufacturing according to Claim 7.

9. Electronic apparatus comprising:
the organic electroluminescence device according to Claim 8.
